# EUROPÄISCHE PATENTSCHRIFT

(11) **EP 1 924 914 B1**
(45) Veröffentlichungstag und Bekanntmachung des Hinweises auf die Patenterteilung: **16.03.2011**
(21) Anmeldenummer: 06778060.1
(22) Anmeldetag: 28.07.2006
(51) Int. Cl.: G06F 11/07, G06F 11/10, G11C 29/52

(54) **DATENVERARBEITUNGSSYSTEM UND BETRIEBSVERFAHREN DAFÜR**
DATA PROCESSING SYSTEM AND A METHOD FOR THE OPERATION THEREOF
SYSTEME DE TRAITEMENT DE DONNEES ET PROCEDE POUR L'EXPLOITER

(30) Priorität: 30.08.2005 DE 102005040917
(43) Veröffentlichungstag der Anmeldung: 28.05.2008
(73) Patentinhaber: ROBERT BOSCH GMBH, 70442 Stuttgart (DE)
(72) Erfinder: WEIBERLE, Reinhard, 71665 Vaihingen/Enz (DE); BOEHL, Eberhard, 72768 Reutlingen (DE)
(86) Internationale Anmeldenummer: PCT/EP2006/064800
(87) Internationale Veröffentlichungsnummer: WO 2007/025817

(56) Entgegenhaltungen:
- EP-A2- 0 096 783
- DE-A1- 1 449 529
- US-A- 4 535 455
- US-A- 4 604 751
- US-A- 4 661 955
- US-B1- 6 675 341
- US-B1- 6 701 480

## Beschreibung

### Stand der Technik

Die vorliegende Erfindung betrifft ein Betriebsverfahren für ein Datenverarbeitungssystem und ein Datenverarbeitungssystem, das eingerichtet ist, das Betriebsverfahren auszuführen.

Systeme zur digitalen Datenverarbeitung werden in zunehmendem Umfang für die Steuerung von komplexen, sicherheitskritischen Prozessen, insbesondere auf dem Kfz-Sektor, eingesetzt. Um die Sicherheit der Benutzer eines solchen Systems bzw. eines Kraftfahrzeugs, in dem ein solches System zum Einsatz kommt, auch im Falle einer Funktionsstörung zu gewährleisten, ist es erforderlich, das Auftreten einer Funktionsstörung so schnell wie möglich zu erkennen und ggf. geeignete Sicherungsmaßnahmen zu treffen. Diese Sicherungsmaßnahmen beruhen häufig in einer Stilllegung des Datenverarbeitungssystems oder zumindest derjenigen Teile des Systems, die von der Funktionsstörung in Mitleidenschaft gezogen sind. So offenbart zum Beispiel DE 100 63 934 A1 ein Datenverarbeitungssystem in Form eines Netzwerks mit einer Mehrzahl von Steuereinheiten, in dem mehrere Überwachungsroutinen ablaufen, die jeweils bei Erfassung eines Fehlers unterschiedliche Abschaltstrategien für Steuereinheiten des Netzwerks auslösen. Durch die diversen Abschaltstrategien wird vermieden, dass bei Erfassung eines Fehlers das gesamte Netzwerk abgeschaltet werden muss, sondern diejenigen seiner Komponenten weiterlaufen können, die von dem Fehler nicht betroffen sind. Aber auch die Abschaltung einzelner Komponenten führt zu einer Einschränkung der Funktionsfähigkeit des Netzwerks.

DE 102 20 811 A1 schlägt vor, eine flexible Reaktion auf unterschiedliche Arten von Fehlern, die in einem Datenverarbeitungssystem auftreten können, mit Hilfe eines modular aufgebauten, an den Funktionseinheiten des zu überwachenden Systems orientierten Überwachungsverfahren zu implementieren. Die Orientierung an den Funktionseinheiten des Systems führt dazu, dass die Struktur des Überwachungsverfahrens von dem zu überwachenden System abhängig ist. Deshalb ist es arbeitsaufwendig, dieses bekannte Verfahren an eine neue Anwendung anzupassen.

US 4 661 955 A1 offenbart ein Betriebsverfahren für ein Datenverarbeitungssystem mit den Schritten
a) Lesen eines Datenworts aus einer Speicherzelle;
b) Überprüfen der Unversehrtheit des Datenworts anhand von redundanter Zusatzinformation; und
c) in dem Fall, dass sich das Datenwort als verfälscht erweist, Ausführen einer Fehlerbehandlungsprozedur;
d) Prüfen der Funktionsfähigkeit der Speicherzelle (S1-S3) und, falls die Speicherzelle für funktionsfähig befunden wird,
e) Wiederherstellen ihres Inhalts (S7, S11).

### Vorteile der Erfindung

Durch die vorliegende Erfindung wird ein Betriebsverfahren für ein Datenverarbeitungssystem geschaffen, das die Integrität von Daten, auf die ein Anwendungsprogramm zugreift, gewährleisten kann, ohne das Anwendungsprogramm störend zu verzögern. Dieser Vorteil wird erreicht durch ein Betriebsverfahren für ein Datenverarbeitungssystem wie in Anspruch 1 definiert.

Das Verfahren ist unabhängig von einem Bedeutungsgehalt, den das Datenwort für ein auf dem Datenverarbeitungssystem laufendes Anwendungsprogramm hat. Es kann daher sowohl eine Programmanweisung als auch Parameter beinhalten.

Die Wiederherstellung kann eine originalgetreue Wiederherstellung oder, falls der Datenwert eine zeitlich veränderliche Variable ist, auch eine Aktualisierung des Inhalts der Speicherzelle sein.

Wenn der Inhalt der Speicherzelle wiederhergestellt ist, kann das Datenverarbeitungssystem seine eigentliche Aufgabe weiter erfüllen; ein Abschalten des Datenverarbeitungssystems oder von Teilen desselben ist nicht mehr erforderlich.

Diese Eigenschaft des erfindungsgemäßen Verfahrens ist besonders vorteilhaft bei modernen Datenverarbeitungssystemen, die Speicher mit einer hohen Integrationsdichte verwenden, da bei diesen Speichern die Wahrscheinlichkeit eines spontanen Datenverlustes durch den Einfluss von Partikelstrahlung, insbesondere Alphateilchen, um so größer ist, je kleiner die Abmessungen einer von einem Strahlungspartikel getroffenen Speicherzelle sind.

Zum Prüfen der Funktionsfähigkeit der Speicherzelle werden vorzugsweise folgende Schritte ausgeführt:
d1) Schreiben in die Speicherzelle;
d2) Rücklesen der beschriebenen Speicherzelle; und
d3) Vergleichen des rückgelesenen Datenwortes mit dem zuvor in die Speicherzelle geschriebenen.

Wenn bei dem Vergleich Übereinstimmung festgestellt wird, kann davon ausgegangen werden, dass ein vorhergehender Datenverlust der Speicherzelle auf einen vorübergehenden äußeren Einfluss zurückzuführen ist und nicht auf eine Störung der Speicherzelle selber, dass also die Speicherzelle weiter benutzt werden kann und das Risiko eines neuerlichen Datenverlustes bei ihr nicht größer ist als bei anderen Zellen des Speichers.

Vorzugsweise ist das in Schritt d1) in die Speicherzelle geschriebene Datenwort das binäre Komplement des in Schritt a) gelesenen Datenwortes, da dann ein einziger Schreibvorgang genügt, um für jedes Bit der Speicherzelle zu überprüfen, dass es in der Lage ist, die Werte 0 und 1 anzunehmen.

Es ist zwar auch möglich, ein fest vorgegebenes Datenwort in die Speicherzelle zu schreiben, doch sind dann zwei Schreib-Rücklese- und Vergleichsvorgänge mit jeweils binär komplementären Datenwörtern erforderlich, um die Funktionsfähigkeit der Speicherzelle nachzuweisen.

Das Wiederherstellen des Inhaltes der Speicherzelle kann einer einfachen Ausgestaltung zufolge dadurch erfolgen, dass in Schritt e) das in Schritt a) gelesene Datenwort in die Speicherzelle zurückgeschrieben wird. Dies ist praktikabel, wenn eine kurzzeitige Fehlerhaftigkeit des Datenwortes keine sicherheitsgefährdenden Auswirkungen im System haben kann und sichergestellt ist, dass zu einem späteren Zeitpunkt das möglicherweise fehlerhafte Datenwort durch eine Aktualisierung richtiggestellt wird.

Sicherer ist, dass in Schritt e) der Inhalt der Speicherzelle aktualisiert wird. Diese Alternative ist jedoch aufwändiger zu implementieren, da Prozeduren zum Aktualisieren des Inhaltes von Speicherzelle zu Speicherzelle verschieden sein können, die Fehlerbehandlungsprozedur also nicht alle Speicherzellen gleich behandeln kann. Falls eine Aktualisierung der Speicherzelle durch eine auf dem Datenverarbeitungssystem laufende Anwendung ohnehin periodisch vorgesehen ist, kann es ausreichend sein, den fehlerhaften Datenwert einfach zu verwerfen und die Aktualisierung abzuwarten.

Eine leicht auf beliebige Speicherzellen anwendbare Alternative ist, dass die redundante Information Fehlerkorrekturinformation (wie zum Beispiel ECC) beinhaltet, und dass in Schritt e) der Inhalt der Speicherzelle anhand der Fehlerkorrekturinformation korrigiert wird.

Zwei oder mehr der oben beschriebenen Alternativen können in einem Verfahren gemeinsam angewendet werden, indem anhand der Adresse der Speicherzelle die Art, in der Schritt e) ausgeführt wird, ausgewählt wird.

Wenn in Schritt d) die Speicherzelle für nicht funktionsfähig befunden wird, sollte eine Routine, die auf die Speicherzelle zugreift, beendet werden, um sicherheitsgefährdende Fehlfunktionen dieser Routine zu vermeiden.

Gegenstand der Erfindung ist auch ein Datenverarbeitungssystem mit einem Datenspeicher und einer programmgesteuerten Schaltung, die programmiert ist, das oben beschriebene Verfahren auszuführen. Bei einem solchen Datenverarbeitungssystem kann es sich insbesondere um ein Kfz-Steuergerät handeln.

Weitere Merkmale und Vorteile der Erfindung ergeben sich aus der nachfolgenden Beschreibung von Ausführungsbeispielen unter Bezugnahme auf die beigefügten Figuren.

### Figuren

- Fig. 1: zeigt ein Blockdiagramm eines erfindungsgemäßen Daten- verarbeitungssystems.
- Fig. 2: zeigt ein Flussdiagramm des erfindungsgemäßen Betriebs- verfahrens.

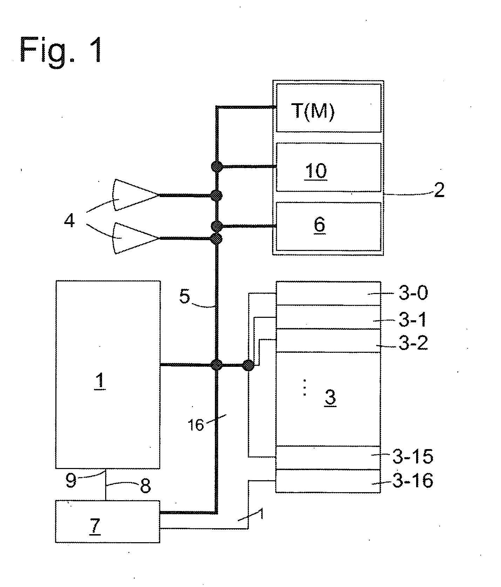

Fig. 1 ist eine schematische Darstellung eines Datenverarbeitungssystems, in dem die vorliegende Erfindung implementiert ist. Das System umfasst einen Mikroprozessor 1, einen Festwertspeicher 2, einen Schreib-Lesespeicher 3 sowie diverse Sensoren 4 und Aktoren, die miteinander über einen Datenbus 5 und einen Adressbus verbunden sind. Die Sensoren 4 und Aktoren dienen zum Erfassen bzw. Beeinflussen von Betriebsparametern eines zu steuernden Gerätes, zum Beispiel eines Kraftfahrzeugmotors. Die Art und Weise, wie von den Sensoren 4 erzeugte Messwerte vom Mikroprozessor 1 verarbeitet werden, um die Aktoren anzusteuern, ist durch ein in einem Bereich 6 des Festwertspeichers 2 gespeichertes Anwendungsprogramm festgelegt.

Der Datenbus 5 zwischen den Speichern 2, 3 und dem Prozessor 1 hat eine Breite von zum Beispiel 16 Bit.

Die Breite des Schreib-Lesespeichers 3 ist um 1 Bit größer als die des Datenbusses 5; das zusätzliche Bit dient zum Speichern eines Paritätsbits zu jedem 16-Bit-Datenwort. Der Schreib-Lesespeicher 3 ist in der Figur in Abschnitte 3-0 bis 3-16 unterteilt dargestellt, die jeweils eines der Bits 0 bis 15 jedes Datenworts bzw. das dazugehörige Paritätsbit aufnehmen. Der das Paritätsbit aufnehmende Abschnitt 3-16 hat einen Datenein- und -ausgang, der mit einem Paritätscontroller 7 verbunden ist. Dieser erzeugt zu jedem in den Schreib-Lesespeicher 3 zu schreibenden Datenwort das korrekte Paritätsbit und gibt es an den Abschnitt 3-16 aus, so dass es zusammen mit dem Datenwort abgespeichert wird bzw. berechnet zu jedem aus dem Speicher gelesenen Datenwort dessen Parität und vergleicht sie mit der gleichzeitig aus dem Abschnitt 3-16 gelesenen Parität. Bei Nichtübereinstimmung liegt ein Fehler des Speichers 3 vor, und der Paritätscontroller 7 erzeugt ein Fehlersignal, das über eine Leitung 8 einem Interrupt-Eingang 9 des Mikroprozessors 1 zugeführt wird.

Eine Fehlerbehandlungsroutine, die durch den Mikroprozessor 1 im Falle des Auftretens eines Fehlersignals am Interrupt-Eingang 9 abzuarbeiten ist, ist in einem Bereich 10 des Festwertspeichers 2 abgelegt. Das Anwendungsprogramm bewerkstelligt die Steuerung und/oder Regelung des Motors durch eine in regelmäßigen Zeitabständen ausgeführte Schleife, in der es Messergebnisse liest, die zuvor von den Sensoren 4 an ihnen zugeordneten Adressen des Speichers 3 hinterlegt worden sind, diese verarbeitet und anhand der Verarbeitungsergebnisse die Aktoren ansteuert. Wenn diese Ansteuerung erledigt ist und bis zum Beginn der nächsten Schleife Zeit übrig ist, liest das Anwendungsprogramm die einzelnen Speicherplätze des Schreib-Lesespeichers 3 aus, nicht, um die gelesenen Inhalte weiter zu verarbeiten, sondern lediglich, um es dem Paritätscontroller 7 zu ermöglichen, die Korrektheit des Inhaltes der einzelnen Speicherzellen zu überprüfen. Während ein vom Paritätscontroller 7 ausgelöster Interrupt während der Steuer- und Regelungsverarbeitung zu einer Verzögerung von zeitkritischen Aufgaben des Mikroprozessors 1 führen kann, ist dies bei dem sukzessiven Lesen der Speicherzellen nach Abschluss der Steuer- und Regelungsaufgaben nicht der Fall. Die Zeit, in der dieses Lesen stattfindet, stellt eine Leistungsreserve des Mikroprozessors 1 dar, und sie kann, wenn nötig, auch genutzt werden, um eine Fehlerbehandlung durchzuführen, ohne dass dies die anderen Aufgaben des Mikroprozessors beeinträchtigt.

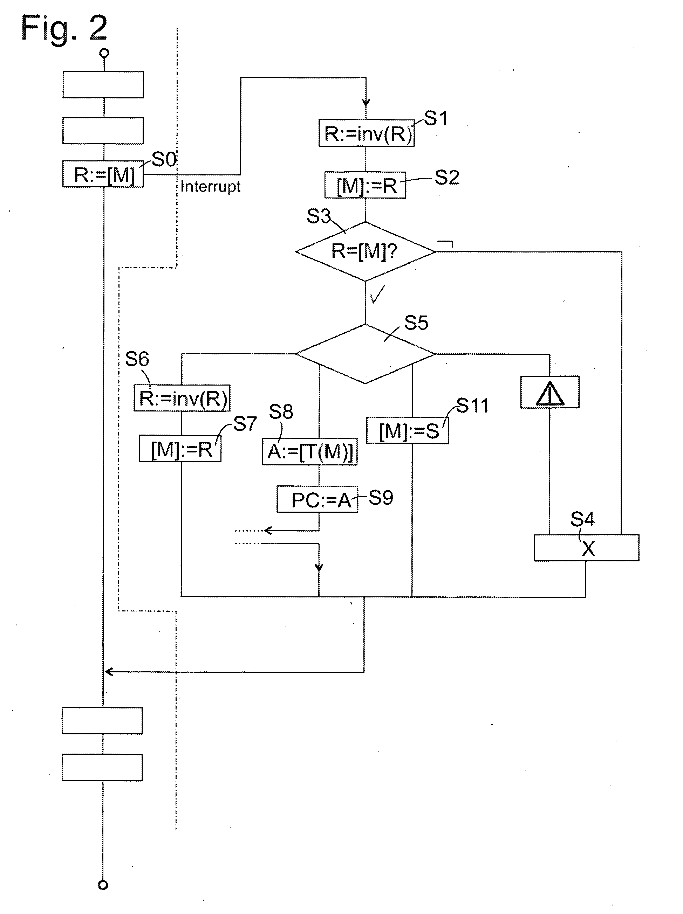

Fig. 2 ist ein Flussdiagramm einer durch einen Interrupt des Paritätscontrollers 7 ausgelösten Fehlerbehandlungsprozedur des Mikroprozessors 1. Dabei bezeichnet der Schritt S0 einen Schritt des Lesens des Inhaltes [M] einer Speicherzelle mit Adresse M in ein Register R des Mikroprozessors 1, bei dem der Paritätscontroller 7 einen Paritätsfehler feststellt. Das daraufhin vom Paritätscontroller 7 ausgegebene Fehlersignal führt zur Unterbrechung des vom Mikroprozessor 1 ausgeführten Anwendungsprogramms und zur Ausführung einer Fehlerbehandlungsprozedur, deren erster Schritt S1 darin beruht, den Inhalt des Registers R durch sein bitweises Komplement inv(R) zu ersetzen. In Schritt S2 wird der Inhalt des Registers R in die Speicherzelle mit der Adresse M geschrieben.

Wenn der festgestellte Paritätsfehler darauf zurückzuführen ist, dass ein Bit der Speicherzelle defekt ist und nur noch einen der zwei möglichen logischen Werte annehmen kann, so wird der Schreibvorgang des Schrittes S2 für dieses Bit ohne Wirkung bleiben.

In Schritt S3 wird der Inhalt [M] der Speicherzelle M erneut gelesen und mit dem Register R verglichen. Wenn die Speicherzelle tatsächlich ein fehlerhaftes Bit aufweist, wird Nichtübereinstimmung festgestellt, und das Verfahren verzweigt nach Schritt S4, in welchem das Anwenderprogramm oder zumindest abtrennbare Teile dieses Programms, die auf die Speicherzelle M zugreifen, beendet werden.

Wenn in Schritt S3 Übereinstimmung festgestellt wird, kann davon ausgegangen werden, dass der Paritätsfehler auf einem spontanen Informationsverlust in einem Bit der Speicherzelle M, zum Beispiel durch den Einfluss von ionisierender Strahlung, verursacht ist und keinen dauerhaften Defekt der Speicherzelle M anzeigt. In diesem Fall kann die Speicherzelle M weiter verwendet werden.

Es wird dann in Schritt S5 entschieden, in welcher Weise der Inhalt der Speicherzelle M wiederherzustellen ist. Die Art und Weise, wie dies zu geschehen hat, kann je nach Bedeutung des in der Speicherzelle M gespeicherten Datenwortes unterschiedlich sein und wird bei der Entwicklung des Anwendungsprogramms festgelegt, zum Beispiel, in den Variablen des Anwendungsprogramms, die im Falle eines Fehlers gleich behandelt werden sollen, in jeweils der Art der Fehlerbehandlung zugeordneten Adressbereichen gespeichert werden.

Wenn ein Fehler der in der Speicherzelle M gespeicherten Variablen toleriert werden kann, beispielsweise, weil die Variable regelmäßig anhand von Messergebnissen der Sensoren 4 neu berechnet wird und ein kurzzeitig falscher Wert der Variablen keine sicherheitsrelevante Fehlsteuerung zur Folge haben kann, genügt es, wenn das Verfahren zu Schritt S6 verzweigt, in welchem das Register abermals invertiert wird, und anschließend in Schritt S7 mit dem so erhaltenen Wert die Speicherzelle M überschrieben wird. Die Speicherzelle M hat dann wieder den gleichen Inhalt wie in Schritt S0. Es besteht zwar die überwiegende Wahrscheinlichkeit, dass dieser Inhalt falsch ist, doch so lange der Fehler nicht die signifikantesten Bits betrifft, stellt er zumindest eine bessere Näherung für den korrekten Wert dar als irgendeine willkürlich vorgegebene Konstante.

Denkbar ist auch, einen als fehlerhaft erkannten Wert einer Speicherzelle durch einen vorgegebenen Wert wie etwa 0x0000 oder 0xFFFF zu ersetzen, der von dem auf die betreffende Speicherzelle zugreifenden Anwendungsprogramm als ungültig erkannt wird. Die angemessene Reaktion auf den Fehler kann dann dem Anwendungsprogramm überlassen bleiben und z.B. unterschiedlich ausfallen, je nachdem, welche Werte andere Variable gegenwärtig haben oder aus welcher Ablaufphase des Anwendungsprogramms auf die fehlerhafte Speicherzelle zugegriffen wurde.

Es kann eine weitere Gruppe von Speicherzellen geben, deren Inhalt im Falle eines Fehlers ohne großen Aufwand neu von den Sensoren 4 gemessen oder neu berechnet werden kann. Routinen zum Neuberechnen oder Messen dieser Werte sind im Allgemeinen Teil des Anwenderprogramms. Eine Tabelle T(M) im Festwertspeicher 2 gibt zu jeder Speicherzelle M dieses Typs eine Anfangsadresse A einer Routine an, mit der der Inhalt [M] neu berechnet oder gemessen werden kann. Diese Adresse A wird in Schritt S8 ermittelt und in Schritt S9 angesprungen, um die betreffende Routine auszuführen und [M] wiederherzustellen.

Es kann eine weitere Gruppe von Speicherzellen M geben, bei denen die mit der Verwendung eines falschen Wertes einhergehende Gefährdung unakzeptabel groß ist, so dass eine einfache Wiederherstellung von [M] durch die Schritte S6, S7 nicht in Betracht kommt, und die auch einer schnellen Neuermittlung durch die Schritte S8, S9 nicht zugänglich sind. Hierzu können zum Beispiel durch eine längerfristige Mittelwertbildung erhaltene Variablen gehören, oder diskrete Variablen, deren Auswirkungen sich nicht stetig mit ihrem Zahlenwert ändern. Wenn die Speicherzelle, die den Paritätsfehler ausgelöst hat, zu dieser Gruppe gehört, wird in Schritt S10 ein Warnsignal an einen Benutzer ausgegeben, um ihn aufzufordern, das erfindungsgemäße Datenverarbeitungssystem neu zu starten, und anschließend geht das Verfahren über zu Schritt S4, in welchem Funktionen, die Speicherzelle M verwenden, so lange gesperrt werden, bis der korrekte Inhalt von M durch einen Systemneustart wiederhergestellt ist.

Eine weitere Möglichkeit ist, von bestimmten Variablen Sicherungskopien anzulegen, so dass, wenn die fehlerhafte Speicherzelle M eine solche Variable enthält, einfach deren Sicherungskopie S gelesen und in die Speicherzelle M zurückgeschrieben werden kann (S11) .

Eine praktische Ausgestaltung der vorliegenden Erfindung kann noch weitere Optionen für die Korrektur eines als fehlerhaft erkannten Inhaltes einer Speicherzelle oder auch nur eine Teilmenge der oben beschriebenen Optionen umfassen. Im einfachsten Fall kann auch der Entscheidungsschritt S5 fehlen und nur eine einzige Option vorgesehen sein.

Einer bevorzugten Weiterentwicklung der Erfindung zufolge enthält der Speicher 3 zu jedem Datenwort nicht nur ein redundantes Bit 3-16, sondern mehrere, deren Inhalt aus dem zugeordneten Datenwort jeweils mittels eines Fehlerkorrekturcodes wie etwa eines Reed-Solomon-Codes bestimmt ist, und die redundanten Bits sind durch den Mikroprozessor 1 adressierbar, so dass auch dieser sie lesen kann. Der Paritätscontroller 7 dient wie bei der Ausgestaltung der Fig. 1 dazu, Fehler in gelesenen Datenwörtern anhand der von ihm gleichzeitig mit jedem Datenwort empfangenen redundanten Bits zu erkennen und im Fehlerfall ein Interrupt des Prozessors 1 auszulösen. Im Verlauf eines solchen Interrupts - oder als eine von mehreren möglichen Optionen für eine Behebung des Speicherfehlers, die im Schritt S5 dieses Interrupts zu Auswahl stehen - liest der Prozessor 1 zu dem fehlerhaften Datenwort die redundanten Bits, korrigiert anhand von diesen das fehlerhafte Datenwort und schreibt es in die von dem Fehler betroffene Speicherzelle zurück.

## Patentansprüche

1. Betriebsverfahren für ein Datenverarbeitungssystem, das einen Mikroprozessor umfasst, mit den Schritten
a) Lesen eines Datenworts aus einer Speicherzelle (S0) durch eine programmierbare Schaltung (1) unter der Kontrolle eines Anwendungsprogramms;
b) Überprüfen der Unversehrtheit des Datenworts anhand von redundanter Zusatzinformation; und
c) in dem Fall, dass sich das Datenwort als verfälscht erweist, Unterbrechen des Anwendungsprogramms, um eine Fehlerbehandlungsprozedur auszuführen, die die Schritte
d) Prüfen der Funktionsfähigkeit der Speicherzellen (S1-S3) und, falls die Speicherzelle für funktionsfähig befunden wird,
e) Wiederherstellen ihres Inhalts (S7, S11) umfasst;
**dadurch gekennzeichnet,**
**dass** Sensoren (4) zum Erfassen von Betriebsparametern eines zu steuernden Geräts dienen, wobei von den Sensoren (4) erzeugte Messwerte von dem Mikroprozessor verarbeitet werden, und
**dass** Schritt a) von der programmierbaren Schaltung (1) unter der Kontrolle eines Anwendungsprogramms ausgeführt wird, und
**dass** das Anwendungsprogramm wenigstens eine Echtzeitfunktion und eine durch jede Echtzeitfunktion unterbrechbare Hintergrundfunktion umfasst, und dass die Hintergrundfunktion den Schritt a) unmittelbar nacheinander für eine Mehrzahl von Speicherzellen ausführt, wobei das Anwendungsprogramm die einzelnen Speicherzellen ausliest, um die Korrektheit des Istwerts der einzelnen Speicherzellen zu überprüfen, und wobei der Inhalt von Speicherzellen im Falle eines Fehlers von den Sensoren (4), die die Betriebsparameter des zu steuernden Geräts erfassen und die Messwerte erzeugen, neu gemessen wird, wobei Routinen zum Messen Teil des Anwendungsprogramms sind, das von dem Mikroprozessor ausgeführt wird.

2. Betriebsverfahren nach Anspruch 1, **dadurch gekennzeichnet, dass** das Prüfen der Funktionsfähigkeit Schritte
d1) Schreiben in die Speicherzelle (S2);
d2) Rücklesen der beschriebenen Speicherzelle (S3); und
d3) Vergleichen des rückgelesenen Datenworts mit dem zuvor in die Speicherzelle geschriebenen Datenwort (S3) umfasst.

3. Betriebsverfahren nach Anspruch 2, **dadurch gekennzeichnet, dass** das in Schritt d1) (S2) in die Speicherzelle geschriebene Datenwort das binäre Komplement des in Schritt a) (S0) gelesenen Datenworts ist.

4. Betriebsverfahren nach Anspruch 3, **dadurch gekennzeichnet, dass** in Schritt e) (S7) das in Schritt a) (S0) gelesene Datenwort in die Speicherzelle (M) zurückgeschrieben wird.

5. Betriebsverfahren nach Anspruch 3, **dadurch gekennzeichnet, dass** in Schritt e) der Inhalt der Speicherzelle (M) aktualisiert wird.

6. Betriebsverfahren nach Anspruch 3, **dadurch gekennzeichnet, dass** die redundante Information Fehlerkorrekturinformation beinhaltet und dass in Schritt e) der Inhalt der Speicherzelle anhand der Fehlerkorrekturinformation korrigiert wird.

7. Betriebsverfahren nach einem der vorhergehenden Ansprüche, **dadurch gekennzeichnet, dass** anhand der Adresse der Speicherzelle (M) die Art, in der Schritt e) ausgeführt wird, ausgewählt wird (S5).

8. Betriebsverfahren nach einem der vorhergehenden Ansprüche, bei dem, wenn in Schritt d) die Speicherzelle für nicht funktionsfähig befunden wird, eine Routine, die auf die Speicherzelle zugreift, beendet wird (S4).

9. Betriebsverfahren nach einem der vorhergehenden Ansprüche, bei dem die Schritte c) bis e) im Rahmen einer Unterbrechung des Anwendungsprogramms ausgeführt werden.

10. Datenverarbeitungssystem mit einem Datenspeicher (3) und einer programmgesteuerten Schaltung (1), die programmiert ist, das Verfahren nach einem der vorhergehenden Ansprüche an einer Speicherzelle (M) des Datenspeichers (3) auszuführen.

11. Datenverarbeitungssystem nach Anspruch 10, **dadurch gekennzeichnet, dass** es ein Kfz-Steuergerät ist.

## Claims

1. Method of operation for a data processing system which comprises a microprocessor, having the following steps:
a) a data word is read from a memory cell (S0) by a programmable circuit (1) under the control of an application program;
b) the intactness of the data word is checked using redundant supplementary information; and
c) if the data word is found to be corrupt, the application program is interrupted in order to perform an error handling procedure which comprises the steps of
d) checking the operability of the memory cell (S1-S3) and, if the memory cell is found to be operable,
e) restoring the content thereof (S7, S11);
**characterized**
**in that** sensors (4) are used for capturing operating parameters for an appliance which is to be controlled, wherein measured values produced by the sensors (4) are processed by the microprocessor, and
**in that** step a) is performed by the programmable circuit (1) under the control of an allocation program, and
**in that** the application program comprises at least one real-time function and a background function which can be interrupted by any real-time function, and
**in that** the background function performs step a) in direct succession for a plurality of memory cells, wherein the application program reads the individual memory cells in order to check the correctness of the actual value of the individual memory cells, and wherein the content of memory cells is measured afresh in the event of an error by the sensors (4) which capture the operating parameters for the appliance which is to be controlled and produce the measured values, routines for measurement being part of the application program which is executed by the microprocessor.

2. Method of operation according to Claim 1, **characterized in that** the checking of operability comprises steps of
d1) writing to the memory cell (S2);
d2) reading back the written memory cell (S3); and
d3) comparing the data word read back with the data word (S3) previously written to the memory cell.

3. Method of operation according to Claim 2, **characterized in that** the data word written to the memory cell in step d1) (S2) is the binary complement of the data word read in step a) (S0).

4. Method of operation according to Claim 3, **characterized in that** in step e) (S7) the data word read in step a) (S0) is written back to the memory cell (M).

5. Method of operation according to Claim 3, **characterized in that** in step e) the content of the memory cell (M) is updated.

6. Method of operation according to Claim 3, **characterized in that** the redundant information contains error correction information and **in that** in step e) the content of the memory cell is corrected using the error correction information.

7. Method of operation according to one of the preceding claims, **characterized in that** the address of the memory cell (M) is used to select the manner in which step e) is performed (S5).

8. Method of operation according to one of the preceding claims, in which, if the memory cell is found not to be operable in step d), a routine which accesses the memory cell is terminated (S4).

9. Method of operation according to one of the preceding claims, in which steps c) to e) are performed as part of interruption of the application program.

10. Data processing system having a data memory (3) and a program-controlled circuit (1) which is programmed to perform the method according to one of the preceding claims on a memory cell (M) in the data memory (3).

11. Data processing system according to Claim 10, **characterized in that** it is a motor vehicle controller.

## Revendications

1. Procédé de fonctionnement pour un système de traitement de données qui comprend un microprocesseur, avec les étapes suivantes :
a) lecture d'un mot de données depuis une cellule de mémoire (S0) par le biais d'un circuit programmable (1) sous le contrôle d'un programme d'application ;
b) vérification de l'intégrité du mot de données au moyen d'informations supplémentaires redondantes ; et
c) dans le cas où le mot de données s'avère altéré, interruption du programme d'application afin d'exécuter une procédure de traitement des erreurs, qui comprend les étapes
d) de contrôle de l'aptitude fonctionnelle de la cellule de mémoire (S1 - S3) et, dans le cas où la cellule de mémoire est constatée fonctionnelle,
e) de rétablissement de son contenu (S7, S11) ;
**caractérisé en ce**
**que** des capteurs (4) servent à détecter les paramètres de fonctionnement d'un appareil à commander, les valeurs mesurées générées par les capteurs (4) étant traitées par le microprocesseur et
**que** l'étape a) est exécutée par le circuit programmable (1) sous le contrôle du programme d'application et
**que** le programme d'application comprend au moins une fonction en temps réel et une fonction en arrière-plan pouvant être interrompue par chaque fonction en temps réel et
**que** la fonction en arrière-plan exécute l'étape a) immédiatement l'une à la suite de l'autre pour une pluralité de cellules de mémoire, le programme d'application lisant les cellules de mémoire individuelles afin de vérifier si la valeur effective de chacune des cellules de mémoire est correcte et le contenu des cellules de mémoire, dans le cas d'une erreur de la part des capteurs (4) qui détectent les paramètres de fonctionnement de l'appareil à commander et génèrent les valeurs mesurées, étant de nouveau mesuré, des routines de mesure faisant partie du programme d'application qui est exécuté par le microprocesseur.

2. Procédé de fonctionnement selon la revendication 1, **caractérisé en ce que** le contrôle de l'aptitude fonctionnelle comprend les étapes
d1) d'écriture dans la cellule de mémoire (S2) ;
d2) de relecture de la cellule de mémoire écrite (S3) ; et
d3) de comparaison du mot de données relu avec le mot de données précédemment écrit dans la cellule de mémoire (S3).

3. Procédé de fonctionnement selon la revendication 2, **caractérisé en ce que** le mot de données écrit dans la cellule de mémoire à l'étape d1) (S2) est le complément binaire du mot de données lu à l'étape a) (S0).

4. Procédé de fonctionnement selon la revendication 3, **caractérisé en ce qu'**à l'étape e) (S7), le mot de données lu à l'étape a) (S0) est réécrit dans la cellule de mémoire (M).

5. Procédé de fonctionnement selon la revendication 3, **caractérisé en ce qu'**à l'étape e), le contenu de la cellule de mémoire (M) est actualisé.

6. Procédé de fonctionnement selon la revendication 3, **caractérisé en ce que** les informations redondantes contiennent une information de correction d'erreur et **en ce qu'**à l'étape e), le contenu de la cellule de mémoire est corrigé au moyen de l'information de correction d'erreur.

7. Procédé de fonctionnement selon l'une des revendications précédentes, **caractérisé en ce que** la manière d'exécuter l'étape e) est sélectionnée (S5) au moyen de l'adresse de la cellule de mémoire (M).

8. Procédé de fonctionnement selon l'une des revendications précédentes, selon lequel, lorsque la cellule de mémoire est constatée non fonctionnelle à l'étape d), une routine qui donne accès à la cellule de mémoire prend fin (S4).

9. Procédé de fonctionnement selon l'une des revendications précédentes, selon lequel les étapes c) à e) sont exécutées dans le cadre d'une interruption du programme d'application.

10. Système de traitement de données comprenant une mémoire de données (3) et un circuit programmable (1) qui est programmé pour exécuter le procédé selon l'une des revendications précédentes sur une cellule de mémoire (M) de la mémoire de données (3).

11. Système de traitement de données selon la revendication 10, **caractérisé en ce qu'**il est un module de commande de véhicule automobile.
